# EUROPÄISCHE PATENTSCHRIFT

(11) **EP 3 076 197 B1**
(45) Veröffentlichungstag und Bekanntmachung des Hinweises auf die Patenterteilung: **19.04.2017**
(21) Anmeldenummer: 16163218.7
(22) Anmeldetag: 31.03.2016
(51) Int. Cl.: G01R 33/30, G01R 33/31, G01N 24/08

(54) **NMR DURCHFLUSSZELLE**
NMR FLOW CELL
CELLULE DE DEBIT NMR

(30) Priorität: 02.04.2015 DE 102015206030
(43) Veröffentlichungstag der Anmeldung: 05.10.2016
(73) Patentinhaber: Bruker BioSpin GmbH, 76287 Rheinstetten (DE)
(72) Erfinder: Hofmann, Martin, 76332 Bad Herrenalb (DE)
(74) Vertreter: Kohler Schmid Möbus Patentanwälte

(56) Entgegenhaltungen:
- EP-A1- 2 407 796

## Beschreibung

Die Erfindung betrifft eine Überwachungszelle zum Durchführen einer Messung einer in einem Reaktionsbehälter erzeugten Reaktionsflüssigkeit in einem NMR-Spektrometer, insbesondere zur Kontrolle einer chemischen Reaktion mittels NMR-Spektroskopie, wobei die Überwachungszelle folgende Bauteile aufweist: Eine hohle NMR-Probensonde für die Aufnahme der im NMR-Spektrometer zu vermessenden Reaktionsflüssigkeit; eine Einlasstransportkapillare zur Aufnahme der Reaktionsflüssigkeit aus dem Reaktionsbehälter und für den Transport der Reaktionsflüssigkeit von dem Reaktionsbehälter hin zur Probensonde; eine Auslasstransportkapillare für den Rücktransport der Reaktionsflüssigkeit von der Probensonde zum Reaktionsbehälter; eine Einrichtung zum Leiten von Temperierfluid um die Einlass- und Auslasstransportkapillaren herum, welche eine Zuleitung für die Hinleitung des Temperierfluids zur Überwachungszelle sowie eine Ableitung für die Rückleitung des Temperierfluids von der Überwachungszelle umfasst, wobei die Zuleitung koaxial innerhalb der Ableitung geführt ist; einen Adapterabschnitt, durch welchen die Transportkapillaren hindurchgeführt sind; und einen Adapterkopf am probenseitigen Ende des Adapterabschnitts, welcher zum Ankoppeln der Transportkapillaren an die Probensonde ausgestaltet ist, wobei die Einlasstransportkapillare in die Probensonde hineinragt und wobei der Adapterkopf die Probensonde lösbar mit dem Adapterabschnitt verbindet.

Eine solche als NMR-Durchflusszelle ausgestaltete Überwachungszelle ist etwa aus der US 8,686,729 B2 oder der parallelen EP 2 407 796 B1 bekannt geworden.

### Hintergrund der Erfindung

Die vorliegende Erfindung betrifft allgemein den Bereich der kontinuierlichen Überwachung chemischer Reaktionen mittels der NMR-Spektroskopie.

Die NMR-Spektroskopie ist eine weit verbreitete Messmethode, mit der chemische Verbindungen analysiert werden können. Üblicherweise wird bei der NMR-Spektroskopie eine zu vermessende Probe in einem Probenröhrchen in eine Probensonde gegeben, welche im NMR-Spektrometer vermessen wird.

Bei der chemischen Reaktionskontrolle geht es im Wesentlichen um die Optimierung von Reaktionsparametern (Temperatur, Druck, Lösemittel, Katalysator,...) mit dem Zweck, das Reaktionsgleichgewicht auf die Produktseite zu verschieben und/oder Fehlreaktionen zu unterdrücken. Um eine permanente Reaktionskontrolle mittels NMR-Spektroskopie zu erhalten müssten somit regelmäßig Proben entnommen werden, was einen großen Aufwand darstellen würde.

Beim Probentransfer sollten die Reaktionsbedingungen (z.B. Temperatur & Druck) eingehalten werden, damit sich die zu vermessende Probe nicht verändert. Dabei spielt der Zeitfaktor eine erhebliche Rolle.

Da das NMR-Spektrometer und der chemische Reaktor räumlich getrennt sind, wird bei der Reaktionskontrolle in einem geschlossenen System das Reaktionsgemisch kontinuierlich aus dem Reaktor in die Probensonde gepumpt, wo es in regelmäßigen Abständen vermessen wird. Hierbei sollten in dem Transportsystem möglichst analoge Bedingungen wie in dem Reaktionsgefäß herrschen. Dies betrifft insbesondere die Reaktionstemperatur.

In der eingangs zitierten US 8,686,729 B2 oder der parallelen EP 2 407 796 B1 ist jeweils eine Durchflusszelle für eine chemische Reaktionskontrolle mittels NMR-Spektroskopie beschrieben. Mit der bekannten Vorrichtung wird kontinuierlich das flüssige Reaktionsgemisch von dem Reaktor bis zur NMR-Probensonde im Messgerät gepumpt, wo die Flüssigkeit vermessen wird.

Das bekannte System funktioniert mit insgesamt vier koaxial ineinander liegenden Schläuchen, wobei die inneren beiden Kapillaren die Transportkapillaren bilden für das Reaktionsgemisch. Die beiden äußeren Schläuche dienen der Zirkulation einer Temperierflüssigkeit. Das System besteht im Wesentlichen aus folgenden vier Teilen:
1. Gehäuse für die Umkehrung der Temperierleitungen
2. Kopplerabschnitt zum Entkoppeln der Transportkapillaren von den Temperierleitungen
3. Keramikkopf zur Trennung der Transportkapillaren in Zu- und Rücklauf und
4. Probensonde (Messzelle), in der nur noch eine Zulaufkapillare des Reaktionsgemischs vorhanden ist.

Um die vier koaxialen Leitungen mit den jeweiligen Zu- und Rückleitungen zu verbinden, bedarf es mehrerer Verbindungsstellen, was zu einer großen Komplexität des Systems führt, wie in vorliegender Fig. 3 (entnommen aus der EP 2 407 796 B1) dargestellt ist.

Außerdem ist bei der bekannten Vorrichtung ein Kopplungsstück (siehe oben Nr. 2.) vorgesehen, welches die Kapillaren des Reaktionsstroms von den Temperierleitungen entkoppelt, um die Kapillaren der Messzelle zuzuführen. Dadurch entsteht ein relativ großer Bereich an dem das Reaktionsgemisch nicht temperiert, sondern der Raumtemperatur exponiert ist. Dies ist insbesondere ein Problem, wenn mit dünnen Kapillaren gearbeitet wird und die Reaktionstemperatur stark von der Raumtemperatur abweicht. In dieser Konstellation kann sich eine exotherme chemische Reaktion verlangsamen, bzw. das thermische Gleichgewicht ändern. Bei Reaktionen die bei Minustemperaturen ablaufen, kann es an dieser exponierten Stelle zu einer unkontrollierbaren Veränderung des Probenzustands kommen.

Es muss auch sichergestellt sein, dass der Durchfluss im Heizbeziehungsweise Kühlkreislauf mit handelsüblichen Umlaufthermostaten betrieben werden kann und die für die Reaktion notwendigen Temperaturen auf der gesamten Länge ohne größeren Verlust erhalten werden kann. Dies bedeutet, dass Widerstände (wie etwa T-Verbinder) in den Temperierleitungen den Fluss beträchtlich reduzieren und somit eine in engen Grenzen gleichbleibende Temperatur auf der gesamten Länge der Probenzuführung nicht garantieren können.

Des Weiteren ist durch die bekannte Konstruktion das Volumen der zurückführenden Probenkapillare ein vielfaches größer als das der Probenzuführungskapillare, nämlich ca. um einen Faktor 5. Dadurch ist die Zirkulation, bis die zu vermessende Probe wieder in den Reaktor zurück transportiert ist, relativ lang, was wiederum die Reaktion im Reaktor negativ beeinflussen kann.

Der Wechsel der Probensonde (*NMR-Flow Tube*) ist nur mit einem speziellen Werkzeug zu bewerkstelligen. Die Fixierung muss dabei irreversibel zerstört werden (*Snap-Cap, zerschneiden mit einer Rasierklinge*).

Ein wesentlicher Faktor, der die Reaktionsgeschwindigkeit chemischer Reaktionen stark beeinflusst, ist -wie erwähnt- die Temperatur. Hierbei besteht die große Schwierigkeit, das chemische Gleichgewicht insbesondere hinsichtlich der Temperatur beizubehalten. Weiterhin sollte das System für die Probenentnahme möglichst einfach aufzubauen sein, d.h. es sollte mit möglichst wenigen Verbindungs- oder Anschlussstellen auskommen. Diese Stellen werden beim Transport von Flüssigkeiten nämlich häufig als Schwachpunkte identifiziert, bei denen Undichtigkeiten auftreten können.

### Aufgabe der Erfindung

Der Erfindung liegt demgegenüber die -im Detail betrachtet relativ anspruchsvolle und komplexe- Aufgabe zugrunde, bei einer Überwachungszelle der eingangs beschriebenen Art mit unaufwändigen technischen Mitteln in den Zu- und Rückleitungen der flüssigen Mess-Probe eine möglichst gleichmäßige Temperatur beizubehalten, um das thermische Gleichgewicht nicht zu beeinflussen, sowie das System für die Probenentnahme derart einfach aufzubauen, dass es mit möglichst wenigen, möglichst genormten und im Handel ohne Weiteres erhältlichen Verbindungs- oder Anschlussstellen auskommt, wobei bereits vorhandene Einrichtungen leicht nachrüstbar sein sollen.

### Kurze Beschreibung der Erfindung

Diese Aufgabe wird durch die vorliegende Erfindung auf ebenso überraschend einfache wie wirkungsvolle Weise dadurch gelöst, dass die Transportkapillaren innerhalb der Zuleitung parallel nebeneinander -und *nicht* koaxial- geführt und beide Transportkapillaren jeweils fluiddicht am Adapterkopf angebracht sind; und dass die Zu- und Ableitung für das Temperierfluid derart ausgestaltet und am Adapterabschnitt angebracht sind, dass eine Umkehrung des Temperierfluidstroms im Adapterabschnitt erfolgt.

Im Vergleich zu der koaxialen Ausführung mit vier ineinander geführten Leitungen, sind in der erfindungsgemäßen Lösung die Transportkapillaren für die Reaktionsgemische getrennt geführt. Die beiden Transportkapillaren für die Hin- und Rückleitung der Reaktionsflüssigkeit von dem Reaktionsbehälter hin zur Probensonde und wieder zurück in den Reaktor sind auf möglichst ganzer Länge bis zur Probensonde von einem Temperierfluid (in der Regel einer Flüssigkeit) umgeben, das es ermöglicht, das Reaktionsgemisch auf der gewünschten Temperatur zu halten.

Das Temperierfluid wird in koaxialen Leitungen geführt, wobei die innere Leitung die Zuleitung und die äußere Leitung die Rückleitung des Temperierfluids zu einem gemeinsamen Behälter ist.

Die Transportkapillaren für das das Reaktionsgemisch werden in unmittelbarer Nähe des Reaktionsbehälters mittels eines vorzugsweise Y-förmigen Anschlussstücks in die Zuleitung eingeführt. In einem weiteren, ebenfalls bevorzugt Y-förmigen Anschlussstück wird die Zuleitung nebst der Transportkapillaren in das Rückleitung eingeführt. Mit Hilfe dieses Aufbaus kann das Reaktionsgemisch bei gleichbleibender Temperatur, über mehrere Meter bis zum NMR-Spektrometer transportiert werden.

Unmittelbar vor der Probensonde wird der Temperierstrom in einem Adapterabschnitt umgekehrt, indem die beiden Temperierleitungen über das Volumen des Adapterstücks kommunizieren.

Das Adapterstück endet Spektrometer-seitig mit einem Verschlusskopf (Adapterkopf), durch welchen lediglich die Transportkapillaren, nicht aber der Temperierstrom hindurchgeführt werden.

Am Adapterkopf ist die Probensonde befestigt, in welche die Einlasstransportkapillare vorzugsweise tiefer eintaucht als die Auslasstransportkapillare. Letztere endet insbesondere am Adapterkopf.

Das Reaktionsgemisch fließt aus der Einlasskapillare in die Probensonde ein und die Sonde wird somit auf das komplette Messvolumen gefüllt und von dem Reaktionsgemisch permanent durchspült.

Durch die Öffnung der Auslasstranskapillare wird das Reaktionsgemisch wieder zurück in den Reaktor transportiert.

Mit der vorliegenden Erfindung werden insbesondere folgende Vorteile erzielt:
- Eine verbesserte Temperaturkontrolle über den gesamten Bereich bis zur Messsonde ist möglich.
- Der Kopplerabschnitt aus dem Stand der Technik fällt weg.
- Weniger Anschlüsse führen zu weniger Schwachstellen für Undichtigkeiten am System und einen einfacheren Aufbau.
- Der einzige untemperierte Bereich ist der Adapterkopf, der aber schon vom Gasstrom des NMR-Spektrometers auf der Seite der Probensonde mittemperiert wird.
- Volumenkontrolle für die Proben-Rückführung wird ermöglicht.
- Eine günstigere Fertigung wird durch eine deutlich geringere Anzahl von erforderlichen Bauteilen sowie durch handelsübliche Dimensionen erreicht.
- Eine leichtere Anpassung an die Applikation wird ermöglicht.

### Bevorzugte Ausführungsformen und Weiterbildungen der Erfindung

Besonders einfach und daher bevorzugt ist eine Ausführungsform der erfindungsgemäßen Überwachungszelle, bei der die Zuleitung und die Ableitung über ein Hohlvolumen des Adapterabschnitts derart miteinander kommunizieren, dass eine Umkehrung des Temperierfluidstroms im Adapterabschnitt erfolgt.

Bei einer weiteren vorteilhaften Ausführungsform der Erfindung taucht die Einlasstransportkapillare tiefer in die Probensonde ein als die Auslasstransportkapillare, insbesondere endet die Auslasstransportkapillare mit einem Verschlusskopf, nämlich dem Adapterkopf, durch welchen lediglich die Transportkapillaren nicht aber der Temperierstrom durchgeführt werden. Die Auslasstransportkapillare taucht dann nicht in die Probensonde ein. Das Reaktionsgemisch fließt aus der Einlasskapillare in die Probensonde ein und die Sonde wird somit auf das komplette Messvolumen gefüllt und von dem Reaktionsgemisch permanent durchspült. Durch die Öffnung der Auslasstranskapillare wird das Reaktionsgemisch wieder zurück in den Reaktor transportiert.

Vorzugsweise sind sowohl der Adapterabschnitt als auch der Adapterkopf nach außen hin Wärme-isoliert aufgebaut. Das Probensonden-seitige Adapterstück wird also derart gestaltet, dass es ebenfalls, wie die gesamte Temperier-Zuleitung, gegen Temperaturverlust isoliert werden kann.

Bei einer bevorzugten Klasse von Ausführungsformen der Erfindung ist der Adapterkopf aus Polytetrafluorethylen (=Teflon ^{®}), vorzugsweise mit Glasfaser-Verstärkung, aufgebaut. Dieses Material ist bruchfester und weniger porös als die im Stand der Technik vorgeschlagene Keramik, was vorteilhaft bei der Reinigung und Wiederverwendung und Inertheit gegenüber chemischen Substanzen ist. Außerdem erlaubt es dieses Material, Bohrungen einzubringen, an welche Standard-Anschlussstücke der Transportkapillaren fluiddicht eingeschraubt werden können.

Das System kann bei Temperaturen von -40°C bis +120°C verwendet werden, vorzugsweise von -10°C bis + 60°C.

Eine weitere vorteilhafte Ausführungsform der erfindungsgemäßen Überwachungszelle zeichnet sich dadurch aus, dass zwischen Probensonde und Adapterkopf ein manuell, vorzugsweise ohne Werkzeug, lösbarer Schnellverschluss, insbesondere ein wiederverwendbarer Bajonett-Verschluss, zum einfachen und schnellen Wechsel der Probensonde bei Verschmutzung, Applikationswechsel, Volumenänderung des Messbereichs vorhanden ist.

Bei bevorzugten Ausführungsformen weisen die Transportkapillaren identisch dimensionierte Außen-Abmaße auf. Der Einsatz von zwei in ihren Außendimensionen identisch dimensionierten Kapillaren für den Probenkreislauf ermöglicht unter anderem auch eine besser Volumenkontrolle für die zurückführende Probenkapillare. Sie kann nun in Bezug auf das interne Volumen frei gewählt werden und im günstigsten Fall identisch mit der der Proben zuführenden Kapillare sein.

Durch die Wahl von handelsüblichen Dimensionen für Kapillaren und Anschlüssen ist das Produkt um ca. 50% günstiger zu fertigen und dabei noch leichter auf die Bedürfnisse der Reaktion (interne Volumen) anzupassen.

Bei weiteren vorteilhaften Ausführungsformen der erfindungsgemäßen Überwachungszelle sind die Transportkapillaren aus chemisch inertem Kunststoff, vorzugsweise aus PTFE aufgebaut. Es werden handelsübliche, chemisch inerte PTFE-Kapillaren eingesetzt, welche die Verwendung von handelsüblichen Verbindungsanschlüssen erlauben und keine Sonderanfertigung von Schlauchverbindern erforderlich machen.

Vorzugsweise weist die Auslasstransportkapillare einen -insbesondere bei Bedarf um das Doppelte- größeren Innendurchmesser als die Einlasstransportkapillare auf. Dies ist vorteilhaft für den Abtransport von eventuell gebildeten Präzipitaten in der Probensonde.

Der Innendurchmesser der Transportkapillaren beträgt je nach Anspruch der Reaktion zwischen 0,1 bis 1,2 mm, besonders bevorzugt ist der Innendurchmesser von 0,25 bis 0,5 mm. Vorzugsweise haben Hin- und Rückleitung 0,5mm Innendurchmesser um den auf der Länge von 4m bis 6m entstehenden Druckabfall bei gleichzeitiger Berücksichtigung des internen Systemvolumens so gering wie möglich zu halten. Der Druckabfall beträgt dann bei einer Pumpleistung von 5ml/min bei Raumtemperatur mit Wasser etwa 1 bar/m (Kapillare).

Vorteilhaft sind auch Ausführungsformen der erfindungsgemäßen Überwachungszelle, bei welchen die Zuleitung und die Ableitung des Temperierfluids über eine Strecke von 3m bis 6m einen Innendurchmesser zwischen 2mm und 10mm, vorzugsweise etwa 3,5mm für die Zuleitung und 7mm für die Ableitung, aufweisen.

Bei weiteren bevorzugten Ausführungsformen der Erfindung ist ein erstes Y-förmiges Einkopplungsstück vorgesehen, mit welchem die Transportkapillaren in die Einrichtung zum Leiten von Temperierfluid eingeführt werden können.

Weiterhin kann beim erfindungsgemäßen System ein zweites Y-förmiges Einkopplungsstück vorgesehen sein, mit welchem die Zuleitung und die Ableitung in die Einrichtung zum Leiten von Temperierfluid eingeführt werden können.

Bei besonders vorteilhaften Weiterbildungen dieser Ausführungsformen schließen ein Einlass und ein Auslass der Y-förmigen Einkopplungsstücke einen Winkel von etwa 45° ein, wodurch der Volumenstrom der Temperierflüssigkeit beim Einsatz von handelsüblichen Umlaufthermostaten immerhin um ca. 40% gegenüber T-förmigen Einkopplungsstücken mit 90° Winkel gesteigert werden kann.

Ganz besonders bevorzugt sind Varianten der Erfindung, bei welchen das Temperierfluid eine Flüssigkeit ist. Eine Temperierung mit Temperiergas wäre deutlich weniger effektiv, da Gas kein guter Wärmeträger ist.

In den Rahmen der vorliegenden Erfindung fällt auch die Verwendung eines Systems mit den oben beschriebenen erfindungsgemäßen Merkmalen zur Reaktionskontrolle einer chemischen Reaktion mittels NMR-Spektroskopie.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Vertikalschnittansicht einer Ausführungsform einer erfindungsgemäßen Überwachungszelle;
- Fig. 2: eine schematische räumliche Ansicht dieser Ausführungsform von der Seite betrachtet; und
- Fig. 3: eine Darstellung einer Überwachungszelle nach dem Stand der Technik.

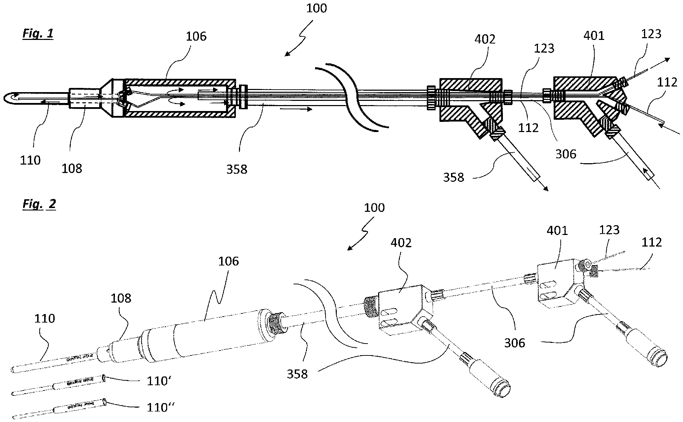

Die Figuren 1 und 2 der Zeichnung zeigen jeweils in einer schematischen Ansicht eine bevorzugte Ausführungsform der erfindungsgemäßen **Überwachungszelle 100**. Diese dient zum Durchführen einer Messung einer in einem Reaktionsbehälter erzeugten Reaktionsflüssigkeit in einem NMR-Spektrometer, insbesondere zur Kontrolle einer chemischen Reaktion mittels NMR-Spektroskopie. Es handelt sich also um eine Durchflusszelle für die chemische Reaktionskontrolle mittels NMR. Mit der erfindungsgemäßen Vorrichtung wird kontinuierlich das Reaktionsgemisch von dem Reaktor bis zur NMR-Probensonde im Messgerät gepumpt, wo es vermessen wird. Hierbei besteht immer die große Schwierigkeit, das chemische Gleichgewicht insbesondere hinsichtlich der Temperatur beizubehalten.

Die Überwachungszelle 100 weist folgende Bauteile auf:
eine hohle **NMR-Probensonde 110** für die Aufnahme der im NMR-Spektrometer zu vermessenden Reaktionsflüssigkeit;
eine **Einlasstransportkapillare 112** zur Aufnahme der Reaktionsflüssigkeit aus dem Reaktionsbehälter und für den Transport der Reaktionsflüssigkeit von dem Reaktionsbehälter hin zur Probensonde 110;
eine **Auslasstransportkapillare 123** für den Rücktransport der Reaktionsflüssigkeit von der Probensonde 110 zum Reaktionsbehälter;
eine Einrichtung zum Leiten von Temperierfluid um die Einlass- und Auslasstransportkapillaren 112, 123 herum, welche eine **Zuleitung 306** für die Hinleitung des Temperierfluids zur Überwachungszelle 100 sowie eine **Ableitung 358** für die Rückleitung des Temperierfluids von der Überwachungszelle 100 umfasst, wobei die Zuleitung 306 koaxial innerhalb der Ableitung 358 geführt ist;
einen **Adapterabschnitt 106**, durch welchen die Transportkapillaren 112, 123 hindurchgeführt sind; und
einen **Adapterkopf 108** am probenseitigen Ende des Adapterabschnitts 106, welcher zum Ankoppeln der Transportkapillaren 112, 123 an die Probensonde 110 ausgestaltet ist, wobei die Einlasstransportkapillare 112 in die Probensonde 110 hineinragt und wobei der Adapterkopf 108 die Probensonde 110 lösbar mit dem Adapterabschnitt 106 verbindet.

Die erfindungsgemäße Überwachungszelle 100 ist dadurch gekennzeichnet, dass die Transportkapillaren 112, 123 innerhalb der Zuleitung 306 parallel nebeneinander -und *nicht* koaxial- geführt und beide Transportkapillaren 112, 123 jeweils fluiddicht am Adapterkopf 108 angebracht sind;
und dass die Zu- und Ableitung 306, 358 für das Temperierfluid derart ausgestaltet und am Adapterabschnitt 106 angebracht sind, dass eine Umkehrung des Temperierfluidstroms im Adapterabschnitt 106 erfolgt.

Die Fixierung der Probensonde 110 mit einem wiederverwendbaren Bajonett-Verschluss (in der Zeichnung nicht dargestellt) ermöglicht eine schnelles, einfaches Wechseln.

Der Volumenstrom der Temperierflüssigkeit wird vor allem durch zwei Maßnahmen verbessert:
- Reduzierung der (relevanten) Schlauchanschlüsse von vorher 28 auf 12.
- Anstelle der sieben T-Verbinder mit 90° Winkeln werden nun zwei Y-Verbinder 401, 402 mit 45° Winkeln eingesetzt, was den Volumenstrom der Temperierflüssigkeit beim Einsatz von handelsüblichen Umlaufthermostate um ca. 40% gesteigert hat.

Der Einsatz von zwei in ihren Außendimensionen identisch dimensionierten Kapillaren 112,123 für den Probenkreislauf ermöglicht auch eine bessere Volumenkontrolle für die zurückführende Probenkapillare 123. Sie kann nun in Bezug auf das interne Volumen frei gewählt werde und im günstigsten Fall identisch mit der der Proben zuführenden Kapillare 112 sein.

Durch die Wahl von handelsüblichen Dimensionen für Kapillaren und Anschlüssen ist das Produkt um ca. 50% günstiger zu fertigen und dabei noch leichter auf die Bedürfnisse der Reaktion (interne Volumen) anzupassen.

Der Adapterkopf 108 wird in der Regel aus Glasfaser-verstärktem Teflon^{®} aufgebaut sein. Dieses Material ist bruchfester und weniger porös als die im Stand der Technik vorgeschlagene Keramik, was vorteilhaft bei der Reinigung und Wiederverwendung sowie für die Inertheit gegenüber chemischen Substanzen ist. Außerdem erlaubt es dieses Material, Bohrungen und Gewinde einzubringen, an welche Standard-Anschlussstücke der Transportkapillaren fluiddicht eingeschraubt werden können.

Das System kann bei Temperaturen von -40°C bis +120°C, insbesondere von - 10°C bis + 60°C, verwendet werden.

Vorzugsweise hat die Auslasstransportkapillare 123 einen größeren Innendurchmesser als die Einlasstransportkapillare 112, vorzugsweise gleich oder bei Bedarf maximal um einen Faktor 2 größer. Dies ist vorteilhaft für den Abtransport von eventuell gebildeten Präzipitaten in der Probensonde 110. Der Innendurchmesser der Transportkapillaren beträgt von 0,1 bis 1,2 mm, besonders bevorzugt ist der Innendurchmesser von 0,25 bis 0,5 mm. Vorzugsweise haben Hin- und Rückleitung 0.5mm ID um den auf der Länge von 4m - 6m entstehenden Druckabfall möglichst gering zu halten. Der Druckabfall beträgt dann bei einer Pumpleistung von 5ml/min bei Raumtemperatur mit Wasser etwa 1 bar/m (Kapillare).

Das erfindungsgemäße System umfasst weiterhin **ein erstes Y-Einkopplungsstück 401**, mit welchem die Transportkapillaren 112, 123 in die Temperierflüssigkeit-Zuleitung 306 geführt werden.

Das beschriebene System umfasst vorzugsweise ein **zweites Y-Einkopplungsstück 402**, mit welchem die Temperierflüssigkeit-Zuleitung 306 in die Temperierflüssigkeit Ableitung 358 eingekoppelt wird.

Es werden handelsübliche, chemisch inerte PTFE Kapillaren eingesetzt, welche die Verwendung von handelsüblichen Verbindungsanschlüssen erlauben. Sonderanfertigungen von Schlauchverbindern erübrigen sich damit.

Das Probensonden-seitige Adapterstück106 ist derart gestaltet, dass es ebenfalls, wie die gesamte Temperier-Zuleitung bzw. gesamte NMR-Durchflusszelle, gegen Temperaturverlust isoliert werden kann.

Außerdem ist eine Fixierung der Probensonde 110 mit einem manuell und ohne spezielles Werkzeug lösbaren Schnellverschluss zum einfachen Wechsel der Probensonde bei Verschmutzung, Applikationswechsel, Volumenänderung des Messbereichs vorgesehen.

Die Erfindung erlaubt die Einführung von mehreren in ihrem Messvolumen **unterschiedlichen Probensonden 110,110',110"**, wie sie in Fig.2 gezeigt sind, um dem Anwender die Möglichkeit einer spezifischen Anpassung an seine Applikation und eine dadurch resultierende Probenkonzentration an die Hand zu geben. Das aktive Volumen im Messbereich kann dann beispielsweise ca. 460µl; 130µl; 90µl betragen.

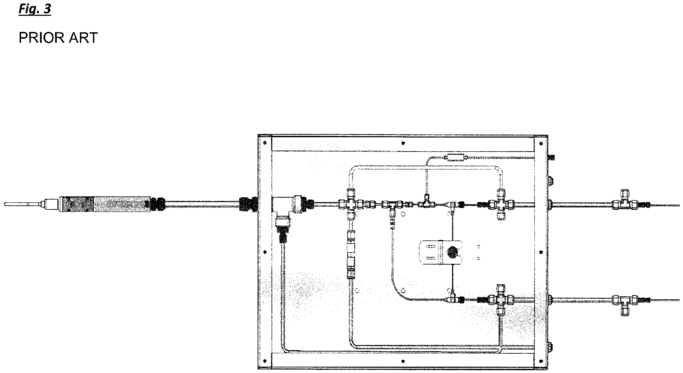

In Fig. 3 schließlich ist die aus dem Stand der Technik bekannte NMR-Durchflusszelle gezeigt, wie sie oben ausführlich diskutiert ist.

## Patentansprüche

1. Überwachungszelle (100) zum Durchführen einer Messung einer in einem Reaktionsbehälter erzeugten Reaktionsflüssigkeit in einem NMR-Spektrometer, insbesondere zur Kontrolle einer chemischen Reaktion mittels NMR-Spektroskopie, wobei die Überwachungszelle (100) folgende Bauteile aufweist:
eine hohle NMR-Probensonde (110) für die Aufnahme der im NMR-Spektrometer zu vermessenden Reaktionsflüssigkeit;
eine Einlasstransportkapillare (112) zur Aufnahme der Reaktionsflüssigkeit aus dem Reaktionsbehälter und für den Transport der Reaktionsflüssigkeit von dem Reaktionsbehälter hin zur Probensonde (110);
eine Auslasstransportkapillare (123) für den Rücktransport der Reaktionsflüssigkeit von der Probensonde (110) zum Reaktionsbehälter;
eine Einrichtung zum Leiten von Temperierfluid um die Einlass- und Auslasstransportkapillaren (112, 123) herum, welche eine Zuleitung (306) für die Hinleitung des Temperierfluids zur Überwachungszelle (100) sowie eine Ableitung (358) für die Rückleitung des Temperierfluids von der Überwachungszelle (100) umfasst, wobei die Zuleitung (306) koaxial innerhalb der Ableitung (358) geführt ist;
einen Adapterabschnitt (106), durch welchen die Transportkapillaren (112, 123) hindurchgeführt sind; und
einen Adapterkopf (108) am probenseitigen Ende des Adapterabschnitts (106), welcher zum Ankoppeln der Transportkapillaren (112, 123) an die Probensonde (110) ausgestaltet ist, wobei die Einlasstransportkapillare (112) in die Probensonde (110) hineinragt und wobei der Adapterkopf (108) die Probensonde (110) lösbar mit dem Adapterabschnitt (106) verbindet;
**dadurch gekennzeichnet,**
**dass** die Transportkapillaren (112, 123) innerhalb der Zuleitung (306) parallel nebeneinander -und *nicht* koaxial- geführt und beide Transportkapillaren (112, 123) jeweils fluiddicht am Adapterkopf (108) angebracht sind;
und **dass** die Zu- und Ableitung (306, 358) für das Temperierfluid derart ausgestaltet und am Adapterabschnitt (106) angebracht sind, dass eine Umkehrung des Temperierfluidstroms im Adapterabschnitt (106) erfolgt.

2. Übervuachungszelle nach Anspruch 1, **dadurch gekennzeichnet, dass** die Zuleitung (306) und die Ableitung (358) über ein Hohlvolumen des Adapterabschnitts (106) derart miteinander kommunizieren, dass eine Umkehrung des Temperierfluidstroms im Adapterabschnitt (106) erfolgt.

3. Überwachungszelle nach einem der vorhergehenden Ansprüche, **dadurch gekennzeichnet, dass** die Einlasstransportkapillare (112) tiefer in die Probensonde (110) eintaucht als die Auslasstransportkapillare (123), insbesondere dass die Auslasstransportkapillare (123) am Adapterkopf (108) endet und nicht in die Probensonde (110) eintaucht.

4. Überwachungszelle nach einem der vorhergehenden Ansprüche, **dadurch gekennzeichnet, dass** der Adapterabschnitt (106) und der Adapterkopf (108) nach außen hin Wärme-isoliert aufgebaut sind.

5. Überwachungszelle nach einem der vorhergehenden Ansprüche, **dadurch gekennzeichnet, dass** der Adapterkopf (108) aus Polytetrafluorethylen (=Teflon ^{®}), vorzugsweise mit Glasfaser-Verstärkung, aufgebaut ist.

6. Überwachungszelle nach einem der vorhergehenden Ansprüche, **dadurch gekennzeichnet, dass** zwischen Probensonde (110) und Adapterkopf (108) ein manuell, vorzugsweise ohne Werkzeug, lösbarer Schnellverschluss, insbesondere ein Bajonett-Verschluss, vorhanden ist.

7. Überwachungszelle nach einem der vorhergehenden Ansprüche, **dadurch gekennzeichnet, dass** die Transportkapillaren (112, 123) identisch dimensionierte Außen-Abmaße aufweisen.

8. Überwachungszelle nach einem der vorhergehenden Ansprüche, **dadurch gekennzeichnet, dass** die Transportkapillaren (112, 123) aus chemisch inertem Kunststoff, vorzugsweise aus PTFE aufgebaut sind.

9. Überwachungszelle nach einem der vorhergehenden Ansprüche, **dadurch gekennzeichnet, dass** die Auslasstransportkapillare (123) einen, vorzugsweise um das Doppelte, größeren Innendurchmesser als die Einlasstransportkapillare (112) aufweist.

10. Überwachungszelle nach einem der vorhergehenden Ansprüche, **dadurch gekennzeichnet, dass** die Transportkapillaren (112, 123) einen Innendurchmesser zwischen 0,1 mm und 1,2mm, vorzugsweise zwischen 0,2 und 0,5mm aufweisen.

11. Überwachungszelle nach einem der vorhergehenden Ansprüche, **dadurch gekennzeichnet, dass** die Zuleitung (306) und die Ableitung (358) über eine Strecke von 3m bis 6m einen Innendurchmesser zwischen 2mm und 10mm, vorzugsweise etwa 3,5mm für die Zuleitung (306) und 7mm für die Ableitung (358), aufweisen.

12. Überwachungszelle nach einem der vorhergehenden Ansprüche, **dadurch gekennzeichnet, dass** ein erstes Y-förmiges Einkopplungsstück (401) vorgesehen ist, mit welchem die Transportkapillaren (112, 123) in die Einrichtung zum Leiten von Temperierfluid eingeführt werden können.

13. Überwachungszelle nach einem der vorhergehenden Ansprüche, **dadurch gekennzeichnet, dass** ein zweites Y-förmiges Einkopplungsstück (402) vorgesehen ist, mit welchem die die Zuleitung (306) und die Ableitung (358) in die Einrichtung zum Leiten von Temperierfluid eingeführt werden können.

14. Überwachungszelle nach Anspruch 12 oder 13, **dadurch gekennzeichnet, dass** ein Einlass und ein Auslass der Y-förmigen Einkopplungsstücke (401, 402) einen Winkel von etwa 45° einschließen.

15. Überwachungszelle nach einem der vorhergehenden Ansprüche, **dadurch gekennzeichnet, dass** das Temperierfluid eine Flüssigkeit ist.

## Claims

1. Monitoring cell (100) for performing a measurement of a reaction fluid produced in a reaction vessel in an NMR spectrometer, in particular for monitoring of a chemical reaction by means of NMR spectroscopy, wherein the monitoring cell (100) has the following components:
a hollow NMR sample probe (110) for receiving the reaction fluid to be measured in the NMR spectrometer;
an inlet transport capillary (112) for receiving the reaction fluid from the reaction vessel and for transport of the reaction fluid from the reaction vessel to the sample probe (110);
an outlet transport capillary (123) for return transport of the reaction fluid from the sample probe (110) to the reaction vessel;
a device for conducting the temperature control fluid around the inlet and outlet transport capillaries (112, 123), which comprises a feed line (306) for feeding the temperature control fluid to the monitoring cell (100) and a return line (358) for return of the temperature control fluid from the monitoring cell (100), the feed line (306) being coaxially guided within the return line (358);
an adapter section (106), through which the transport capillaries (112, 123) are fed; and
an adapter head (108) on the sample side end of the adapter section (106), which is configured for coupling of the transport capillaries (112, 123) to the sample probe (110), wherein the inlet transport capillary (112) extends into the sample probe (110), and wherein the adapter head (108) removably connects the sample probe (110) to the adapter section (106);
**characterized in that**
the transport capillaries (112, 123) are guided within the feed line (306) in parallel next to one another - and *not* coaxially - and both transport capillaries (112, 123) are attached in a fluid-tight manner to the adapter head (108);
and that the feed and the return lines (306, 358) are configured for the temperature control fluid and attached to the adapter section (106) in such a way that a reversal of the temperature control fluid stream occurs in the adapter section (106).

2. Monitoring cell according to claim 1, **characterized in that** the feed line (306) and the return line (358) communicate with one another via a hollow volume of the adapter section (106) in such a way that the temperature control fluid stream is reversed in the adapter section (106).

3. Monitoring cell according to one of the preceding claims, **characterized in that** the inlet transport capillary (112) immerses more deeply in the sample probe (110) than the outlet transport capillary (123), in particular that the outlet transport capillary (123) terminates at the adapter head (108) and does not immerse in the sample probe (110).

4. Monitoring cell according to one of the preceding claims, **characterized in that** the adapter section (106) and the adapter head (108) comprise a heat insulation toward the outside.

5. Monitoring cell according to one of the preceding claims, **characterized in that** the adapter head (108) is made from polytetrafluoroethylene (=Teflon®), preferably with fiberglass reinforcement.

6. Monitoring cell according to one of the preceding claims, **characterized in that** between the sample probe (110) and the adapter head (108) there is a quick-release connector, in particular a bayonet connector that can be detached manually, preferably without tools.

7. Monitoring cell according to one of the preceding claims, **characterized in that** the transport capillaries (112, 123) have identical outer dimensions.

8. Monitoring cell according to one of the preceding claims, **characterized in that** the transport capillaries (112, 123) are made from chemically inert plastic, preferably from PTFE.

9. Monitoring cell according to one of the preceding claims, **characterized in that** the outlet transport capillary (123) has a larger inner diameter, preferably twice as large, as the inlet transport capillary (112).

10. Monitoring cell according to one of the preceding claims, **characterized in that** the transport capillaries (112, 123) have an inner diameter between 0.1 mm and 1.2 mm, preferably between 0.2 and 0.5 mm.

11. Monitoring cell according to one of the preceding claims, **characterized in that** over a distance of 3 m to 6 m, the feed line (306) and the return line (358) have an inner diameter between 2 mm and 10 mm, preferably around 3.5 mm for the feed line (306) and 7 mm for the return line (358).

12. Monitoring cell according to one of the preceding claims, **characterized in that** a first Y-shaped coupling piece (401) is provided, with which the transport capillaries (112, 123) can be inserted into the device for conducting the temperature control fluid.

13. Monitoring cell according to one of the preceding claims, **characterized in that** a second Y-shaped coupling piece (402) is provided, with which the feed line (306) and the return line (358) can be inserted in the device for conducting the temperature control fluid.

14. Monitoring cell according to claims 12 or 13, **characterized in that** an inlet and an outlet of the Y-shaped coupling pieces (401, 402) enclose an angle of around 45°.

15. Monitoring cell according to one of the preceding claims, **characterized in that** the temperature control fluid is a liquid.

## Revendications

1. Cellule de surveillance (100) pour l'exécution d'une mesure d'un liquide réactionnel produit dans une chambre de réaction dans un spectromètre RMN, en particulier pour le contrôle d'une réaction chimique par spectroscopie RMN, la cellule de surveillance (100) présentant les composants suivants :
une sonde d'échantillonnage RMN creuse (110) pour recevoir le liquide réactionnel devant faire l'objet d'une mesure dans le spectromètre RMN;
un capillaire de transport d'entrée (112), pour recevoir le liquide réactionnel provenant de la chambre de réaction, et pour le transport du liquide réactionnel de la chambre de réaction à la sonde d'échantillonnage (110) ;
un capillaire de transport de sortie (123) pour le renvoi du liquide réactionnel de la sonde d'échantillonnage (110) à la chambre de réaction ;
un dispositif pour diriger un fluide d'équilibrage de la température autour des capillaires de transport d'entrée et de sortie (112, 123), qui comprend une conduite d'amenée (306) pour envoyer le fluide d'équilibrage de la température vers la cellule de surveillance (100), ainsi qu'une évacuation (358) pour le retour du fluide d'équilibrage de la température provenant de la cellule de surveillance (100), la conduite d'amenée (306) étant guidée coaxialement à l'intérieur de l'évacuation (358) ;
un segment adaptateur (106), par lequel passent les capillaires de transport (112, 123) ; et
une tête adaptatrice (108) à l'extrémité côté échantillon du segment adaptateur (106), qui est configurée pour raccorder les capillaires de transport (112, 123) à la sonde d'échantillonnage (110), le capillaire de transport d'entrée (112) pénétrant dans la sonde d'échantillonnage (110), et la tête adaptatrice (108) reliant la sonde d'échantillonnage d'une manière amovible au segment adaptateur (106) ;
**caractérisée en ce que**
les capillaires de transport (112, 123) sont guidés à l'intérieur de la conduite d'amenée (306) parallèlement les uns aux autres - et non pas coaxialement - et chacun des deux capillaires de transport (112, 123) est rapporté à la tête adaptatrice (108) d'une manière étanche aux fluides ;
et que la conduite d'amenée et l'évacuation (306, 358) destinées au fluide d'équilibrage de la température sont configurées, et rapportées au segment adaptateur (106), de telle sorte qu'il en résulte une inversion du courant de fluide d'équilibrage de la température dans le segment adaptateur (106).

2. Cellule de surveillance selon la revendication 1, **caractérisée en ce que** la conduite d'amenée (306) et l'évacuation (358) communiquent l'une avec l'autre, par l'intermédiaire d'un volume creux du segment adaptateur (106), de telle sorte qu'il en résulte une inversion du courant de fluide d'équilibrage de la température dans le segment adaptateur (106).

3. Cellule de surveillance selon l'une des revendications précédentes, **caractérisée en ce que** le capillaire de transport d'entrée (112) s'enfonce dans la sonde d'échantillonnage (110) plus profondément que le capillaire de transport de sortie (123), en particulier que le capillaire de transport de sortie (123) se termine au niveau de la tête adaptatrice (108) et ne s'enfonce pas dans la sonde d'échantillonnage (110).

4. Cellule de surveillance selon l'une des revendications précédentes, **caractérisée en ce que** le segment adaptateur (106) et la tête adaptatrice (108) sont réalisés thermiquement isolés vers l'extérieur.

5. Cellule de surveillance selon l'une des revendications précédentes, **caractérisée en ce que** la tête adaptatrice (108) est réalisée en polytétrafluoréthylène (= Teflon®), de préférence avec un renforcement par des fibres de verre.

6. Cellule de surveillance selon l'une des revendications précédentes, **caractérisée en ce qu'**une fermeture rapide, démontable manuellement, de préférence sans outil, en particulier une fermeture à baïonnette, est présente entre la sonde d'échantillonnage (110) et la tête adaptatrice (108).

7. Cellule de surveillance selon l'une des revendications précédentes, **caractérisée en ce que** les capillaires de transport (112, 123) présentent des dimensions extérieures identiques.

8. Cellule de surveillance selon l'une des revendications précédentes, **caractérisée en ce que** les capillaires de transport (112, 123) sont réalisés en un plastique chimiquement inerte, de préférence en PTFE.

9. Cellule de surveillance selon l'une des revendications précédentes, **caractérisée en ce que** les capillaires de transport de sortie (123) présentent un diamètre intérieur plus grand, de préférence deux fois plus grand, que le capillaire de transport d'entrée (112).

10. Cellule de surveillance selon l'une des revendications précédentes, **caractérisée en ce que** les capillaires de transport (112, 123) présentent un diamètre intérieur compris entre 0,1 mm et 1,2 mm, de préférence entre 0,2 et 0,5 mm.

11. Cellule de surveillance selon l'une des revendications précédentes, **caractérisée en ce que** la conduite d'amenée (306) et l'évacuation (358) présentent, sur un tronçon de 3 m à 6 m, un diamètre intérieur compris entre 2 mm et 10 mm, de préférence d'environ 3,5 mm pour la conduite d'amenée (306) et de 7 mm pour l'évacuation (358).

12. Cellule de surveillance selon l'une des revendications précédentes, **caractérisée en ce qu'**est prévu un premier raccord d'injection (401) en Y, à l'aide duquel les capillaires de transport (112, 123) peuvent être insérés dans le dispositif pour diriger le fluide d'équilibrage de la température.

13. Cellule de surveillance selon l'une des revendications précédentes, **caractérisée en ce qu'**est prévu un deuxième raccord d'injection (402) en Y, à l'aide duquel il est possible d'insérer la conduite d'amenée (306) et l'évacuation (358) dans le dispositif pour diriger le fluide d'équilibrage de la température.

14. Cellule de surveillance selon la revendication 12 ou 13, **caractérisée en ce qu'**une entrée et une sortie des raccords d'injection (401, 402) en Y font entre elles un angle d'environ 45°.

15. Cellule de surveillance selon l'une des revendications précédentes, **caractérisée en ce que** le fluide d'équilibrage de la température est un liquide.
